# EUROPEAN PATENT SPECIFICATION

(11) **EP 0 713 360 B1**
(45) Date of publication and mention of the grant of the patent: **29.03.2000**
(21) Application number: 96102172.2
(22) Date of filing: 13.01.1994
(51) Int. Cl.: H05K 7/14

(54) **Input-output unit**
Eingabe/Ausgabe-Einrichtung
Unité d'entrée/sortie

(30) Priority: 18.02.1993 JP 2923693; 22.02.1993 JP 3182493; 26.02.1993 JP 3802193
(43) Date of publication of application: 22.05.1996
(62) Divisional of application: 94100450.9
(73) Proprietor: Yokogawa Electric Corporation, Tokyo 180-8750 (JP)
(72) Inventor: Tamura, Hiroshi, Sayama-shi, Saitama 350-13 (JP); Kamata, Yoshiyuki, Ome-shi, Tokyo 198 (JP); Fujimori, Mitsuaki, Musashino-shi, Tokyo 180 (JP)
(74) Representative: Henkel, Feiler, Hänzel

(56) References cited:
- DE-A- 2 928 668
- DE-A- 3 932 005
- DE-U- 9 102 101
- US-A- 3 992 654
- US-A- 5 436 794

## Description

### Field of the invention

This invention relates to an input-output unit which is used in industrial control equipment and performs signal receiving from and delivery to field devices, and particularly relates to an improvement in construction which realizes high density mounting and which is easy to assemble and with which instrumentation work is easy.

### Description of the Prior Art

An input-output unit is housed in a unit housing box body such as that disclosed in Japanese Laid-Open Patent Publication No. H5-29777 and performs signal receiving and delivery for an industrial control system. The functions of this kind of input-output unit receive/deliver signals to/from the detector terminals of flowmeters, pressure gauges and the like and the manipulating terminals of electric valves and the like and connect them with a higher central control device, and in particular there are those for analog signals which use 4mA-20mA, etc., analog instrumentation signals, signals from thermocouples and the like, and those for digital signals which handle on/off signals, pulse string signals and the like. A specific configuration is for example disclosed in Japanese Laid-Open Utility Model Publication No. H4-88093.

In the past it has been low integration density of the ICs which comprise the electric circuits that have performed the signal conversion consequently the number of signals that can be handled by one unit has been small and the input-output cards that are accommodated in the slots of the input-output unit have been relatively large. As a result, the number of signal wires connected to one unit has also been small, and it has been easy to secure space for positioning terminal blocks. However, as the integration density of ICs becomes higher, the number of signals handled by one unit also increases, to 16 points, 32 points, 64 points, etc.. When this happens, when the number of input-output signals is simply increased, because a large number of signal wires have to be handled in a confined space, the wiring work is time-consuming and there has been the danger of signal wires being connected to the wrong terminals by mistake.

Secondly, to maintain certain cards it is necessary to remove them from the input-output unit, and the interruption of control in the control loop that accompanies this maintenance is not beneficial to the system being controlled. For this reason, in the case of an input-output unit for control use, it is desirable that the control loops of each of the signals be handled by an independent card, and that even when a certain card is being maintained, the other cards remain loaded in the unit and continue to control in those loops. Therefore, in input-output units for control use, a separate card is provided for each control loop; however, because card forms are becoming smaller than they have been in the past, there has been the problem that the loading/removal members become large and loading/removal work becomes awkward when conventional loading/removal mechanisms are employed.

Thirdly, in some cases an input-output unit performs relatively simple intermediary functions such as display functions and warning signal receiving as well as control functions. However, in the past, input-output units of different types have been used to handle analog signals and digital signals. In such cases, for the manufacturer, there is the problem that the number of components required increases and parts management becomes complicated, and, the benefits of mass-production can not be achieved and costs become high. And, from the user's point of view, there has been the problem that because the forms of the various input-output units are not necessarily standardized, when the units are to be accommodated in a cabinet or the like, the combinations of input-output units that can be installed together are limited, and the freedom with which units can be selected is limited.

Fourthly, when the outside signal wires are connected to an input-output unit of this kind, a terminal block is used. For example, a on/off signal is assigned a terminal set comprising a plus terminal and a minus terminal, and in the case of a thermocouple input a circuit for performing cold junction compensation is provided, and, when a large number of signals are to be inputted, common minus terminals are sometimes used. However, there has been the problem that when a different terminal block is designed for each purpose in this way, the number of molds for plastic molding increases and the initial investment in manufacturing equipment increases.

Fifth, when connectors are used for the connection to an input-output unit of this kind, an interface section equipped with a display is used. However, when display devices are mounted in the interface section, there has been the problem that when light guides are used the number of components increases and the assembly work becomes complicated.

Prior art document DE-A-39 32 005 describes a box body of a so-called programmable controller (PLC). According to this PLC, a printed circuit board is fitted at the side of an inserting part of a module body and a terminal block is provided at the side of a LED indicator.

### Summary of the invention

A first aim of this invention is to provide an input-output unit which can be manufactured at a low cost based on the economic benefits of mass-production, using a box body to take in cards which can flexibly handle a wide range of different input-output signals.

A second aim of this invention is to provide an input-output unit which can be manufactured at a low cost based on the economic benefits of mass-production, using a terminal block which can flexibly handle a wide range of different input-output signals.

A third aim of this invention is to provide an input-output unit having an interface section which is equipped with a display device but has a small number of components and is easy to assemble.

To solve this object the present invention provides an input-output unit as specified in claim 1.

An aspect of the present invention which achieves the first aim is, in an input-output unit which performs signal receiving and delivery mediation between an industrial control equipment and the field devices being controlled by it, the provision of the following: an input-output nest 70, connected by a bus to the industrial control equipment; input-output printed circuit boards 80, which are accommodated in this input-output nest 70 and which perform signal conversion between the signal forms handled by the industrial control equipment and the signal forms handled by the field devices; an interface section 90, mechanically mounted on the input-output nest 70, to which signal wires connected to the field devices are connected and which electrically connects these signal wires to the input-output cards.

In an aspect of the present invention which achieves the second aim, in a terminal block having a terminal block 60, in which a plurality of terminals to which signal wires are connected are disposed in rows, and a back board 62, which has a pattern which is connected to the terminals, mounted on the bottom surface of this terminal block 60, the terminal block has a ready indicator chamber 616 and a circuit board accommodating chamber 618 disposed in the row direction in which the terminals are disposed, and, in the ready indicator chamber, light emitted by a light emitting device 626, mounted on the back board, for indicating the operating state of the terminal block, is guided to the upper surface of the terminal block, and, in cases when the signal state of the terminals of the terminal block is to be indicated, an indicator circuit board 64 on which light emitting devices 642, which light up and go out according to the signal states of the terminals, is accommodated in the circuit board accommodation chamber, and an partitioned light guide part 644 which constitutes the upper surface of the terminal block and which in the row direction in which the terminals are disposed separately displays the light emitted by each of these light emitting devices, is mounted in the circuit board accommodating chamber, and, in cases when the terminal block is for thermocouple inputs, a temperature compensation unit 66, which makes thermal contact with terminals to which a thermocouple is connected and measures the temperature of those terminals, is mounted in the circuit board accommodating chamber.

In an aspect of the present invention which achieves the third aim, in a box body for an electronic apparatus having a printed circuit board 91 and an indicator circuit board 92 which has light emitting devices mounted on it and is connected to this printed circuit board through a cable 922, a case 93 whose side surface is larger than the printed circuit board 91 and which accommodates the indicator circuit board 92 on the back of an indicator window 931 mounted at the front of the case 93, and a cover 94 which is fitted to the back of the case 93, the indicator circuit board 92 is provided with holding holes 921 and the indicator window 931 is provided with holding projections 937 which project from the back of the indicator window 931 and engage with the holding holes 921 and the indicator circuit board 92 is held by the holding projections 937 and an edge portion of the printed circuit board 91.

### BRIEF DESCRIPTION OF THE DRAWINGS

Fig. 1 is a construction drawing showing an input-output unit useful for the understanding of the present invention;
Fig. 2 is a view illustrating the connection between a terminal block part 20 and a back board 14;
Fig. 3 is a development view of a sheet that is affixed to a terminal cover 24;
Fig. 4 is a view illustrating the way in which the sheet shown in Fig. 3 is affixed to the terminal cover 24;
Fig. 5 is a construction drawing of an input-output card 50;
Fig. 6 is a view illustrating an ejector part 54;
Fig. 7 is a view illustrating a device which indicates the operating state of an input-output card 50;
Fig. 8 is a construction drawing showing a preferred embodiment of the present invention;
Fig. 9 is a construction drawing of a connector-type interface section fitted to an input-output nest;
Fig. 10 is a construction drawing of an input-output nest;
Fig. 11 is a schematic construction drawing of a terminal block 60;
Fig. 12 is a view illustrating an expansion function which is mounted in a circuit board accommodating chamber;
Fig. 13 is a cross-sectional view of a terminal block having an indicating function;
Fig. 14 is a cross-sectional view of a terminal block having a temperature compensation unit 66;
Fig. 15 is a cross-sectional view illustrating the details of a ready display chamber 616;
Fig. 16 is an upper surface view showing the state of a display sheet affixed to a cover 65;
Fig. 17 is a construction view of a connector-type interface section;
Fig. 18 is an enlarged view of the vicinity of a display window 931;
Fig. 19 is a development view of parts with a cover 94 omitted; and
Fig. 20 is a view of the parts of a case 93.

### DETAILED DESCRIPTION OF A PREFERRED EMBODIMENT

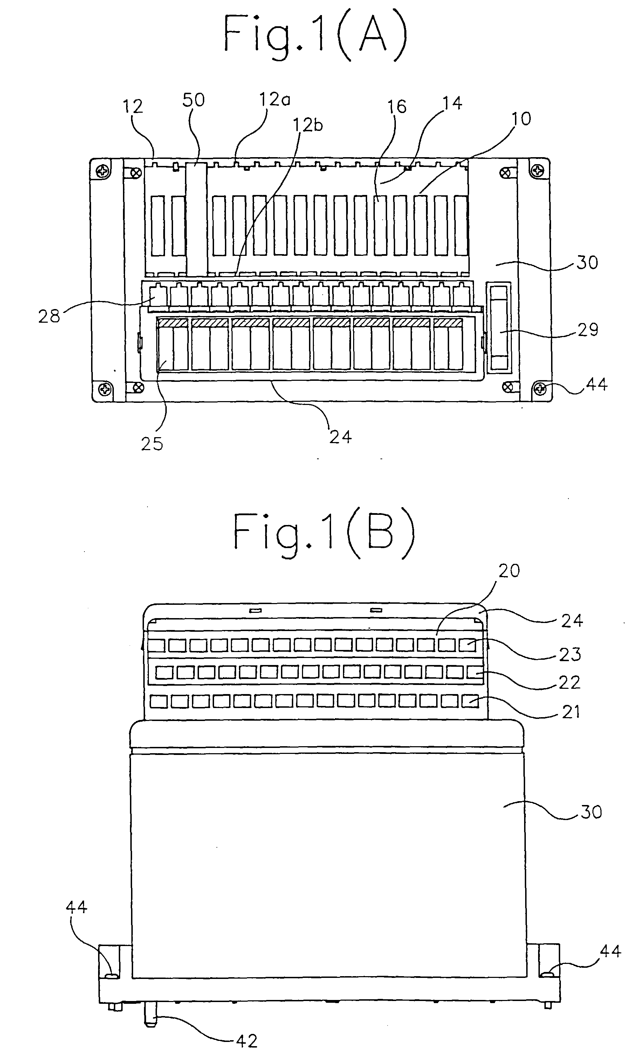

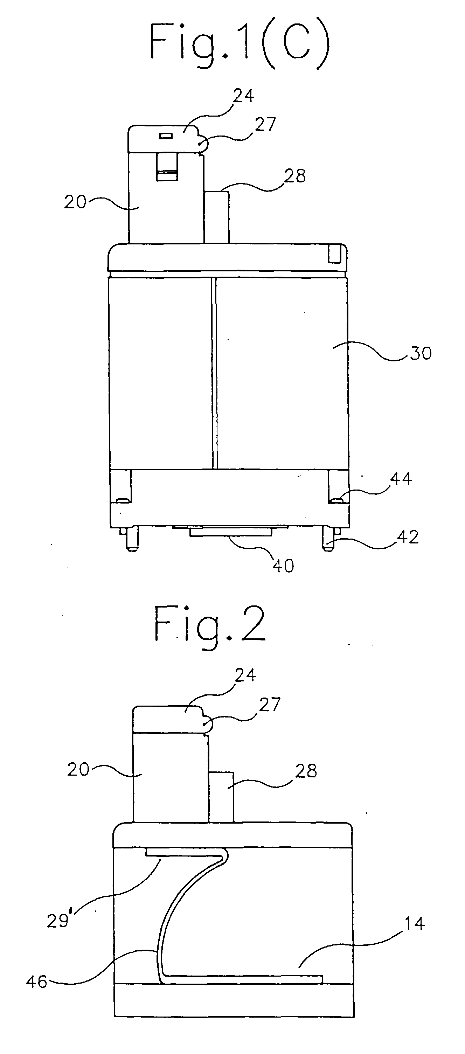

The invention will now be explained in detail, using the accompanying drawings. Fig. 1 is a construction drawing of an input-output unit useful for the understanding of the present invention, in which (A) is a plan view, (B) is a front elevational view and (C) is a side elevational view. In Fig. 1, a card accommodating chamber 10 is provided with a plurality of slots 12 for accommodating input-output cards 50, and in this example there are 16 slots disposed in a row. An upper guide groove 12a and a lower guide groove 12b, oriented in the insertion direction of the input-output cards 50, are disposed as a pair in each slot 12. A back board 14 is mounted at the back of the card accommodating chamber 10, and connectors 16 are mounted on the back board 14 in correspondence with the slots 12. The connectors 16 connect with connectors 56 mounted on the back ends of the input-output cards 50; certain poles are connected to a terminal block part 20, and the other poles are connected to a bus connected to the system side.

The terminal block part 20 has terminals in sets of two or three, and these sets of terminals correspond to the slots 12. In this example there are three terminals per set: a lower row terminal 21, a middle row terminal 22 and an upper row terminal 23. The middle row terminals 22 are offset by half their pitch with respect to the lower row terminals 21 and the upper row terminals 23 in order facilitate the work of connecting the field device signal wires. It is desirable that terminals having mechanisms to prevent the screws falling out be used for these terminals, because this makes the installation work easier.

A terminal cover 24 covers the lower row terminals 21, the middle row terminals 22 and the upper row terminals 23, and this terminal cover 24 can be opened and closed about a shaft part 27; when wire connecting work is to be carried out it is opened, and in the normal operating state it is closed, protecting the terminals. Universal receiving chambers 28 are mounted on the card accommodating chamber side of the terminal block part 20, and are used to mount RJC units for performing temperature compensation in cases when the signal wires are thermocouples and to connect backup apparatus when the control device is in a semiautomatic state, etc.. A slot indicator sheet 25 and a terminal indicator sheet 26 are affixed to the front side and the back side respectively of the terminal cover 24; the details of these sheets will be described later. A connector connecting part 29 is provided for handling the same signals as the terminal block 20 or for handling other, different signals; it is also called a second output.

The card accommodating chamber 10 and the terminal block 20 are mounted on the front of a case part 30, and system side connectors 40 are mounted on the back of this case 30. In order efficiently to release the heat produced by the input-output cards 50 into the outside air, the case 30 is made of a material having good thermal conductivity such as aluminum or the like, and is also suitably provided with ventilation holes. The system side connectors 40 are connected to a back unit (not shown in the drawings), and for positioning purposes a pair of projecting portions 42 are provided on the back side of the case part 30. Mounting screws 44 are disposed at the four corners of the case part 30 and are used to mount the case part 30 on the back unit. The back unit is accommodated in a cabinet or the like, and is provided with a bus which is connected to the central control device of the system side.

The input-output cards 50 input signals from the signal wires connected to the terminal block part 20, perform control computation on these signals, output control signals, and convert these inputted signals into signals for feeding into the bus which is connected to the connectors 16. Here, the input-output cards 50 are assigned one-on-one to the signals that they handle, and in Fig. 1 one card only is installed in the card accommodating chamber 10 and the other slots are empty.

Fig. 2 is a view illustrating the connection between the terminal block part 20 and the back board 14. It is necessary for each set of contacts of the terminal block part 20 to be connected to the poles of the connector 16, on the back board 14, of the corresponding slot 12. Here, if a terminal board 29' mounted on the back of the terminal block part 20 can be connected en bloc to the terminals of the back board 14, the wiring work can be done smoothly. In this preferred embodiment, the terminal board 29' and the back board 14 are constructed integrally using a printed circuit board of a rigidity such that it can be bent (a flex-rigid circuit board) 46, and the wiring patterns of both the terminal board 29' and the back board 14 should not be constructed of separate printed circuit boards, and the two connected by a multiple core flexible cable.

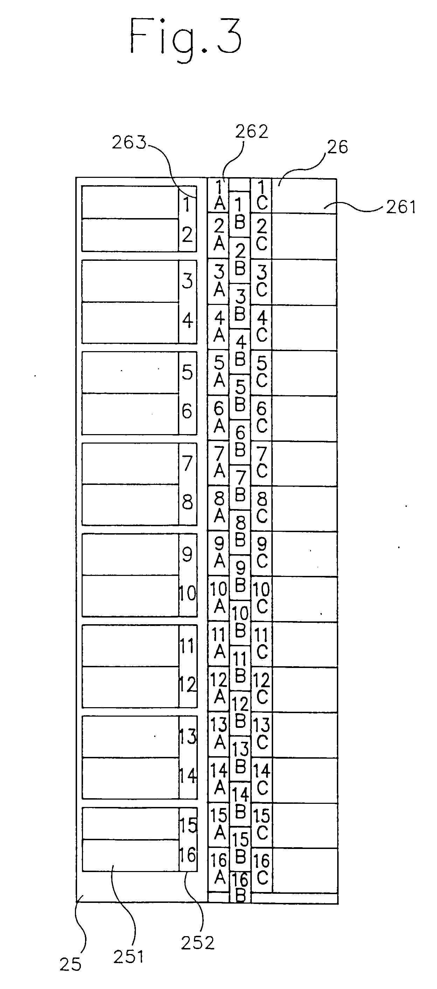

Fig. 3 is a development view of the sheet which is affixed to the terminal cover 24. The slot indicator sheet 25 and the terminal indicator 26 are printed on either side of a fold line 263, and the sheet is folded into two along the fold line 263 and affixed to the terminal cover 24 in such a way as to cover the front and rear sides of the cover 24. The slot indicator sheet 25 is made up of a tag indicator column 251 and a slot number column 252, and the tag names of the input-output cards 50 inserted into the slots 12 are written in the tag indicator column 251. The terminal indicator sheet 26 is made up of a tag indicator column 261 and a terminal number column 262, and the tag names of the field devices connected are written in the tag indicator column 261. The lower row terminals 21, the middle row terminals 22 and the upper row terminals 23 of the terminal block part 20 are indicated in the terminal number column 262; the terminals of slot one are for example marked 1A, 1B, 1C. (In instrumentation, a 'tag name' is a name given to each object of control in order to distinguish the objects of control.)

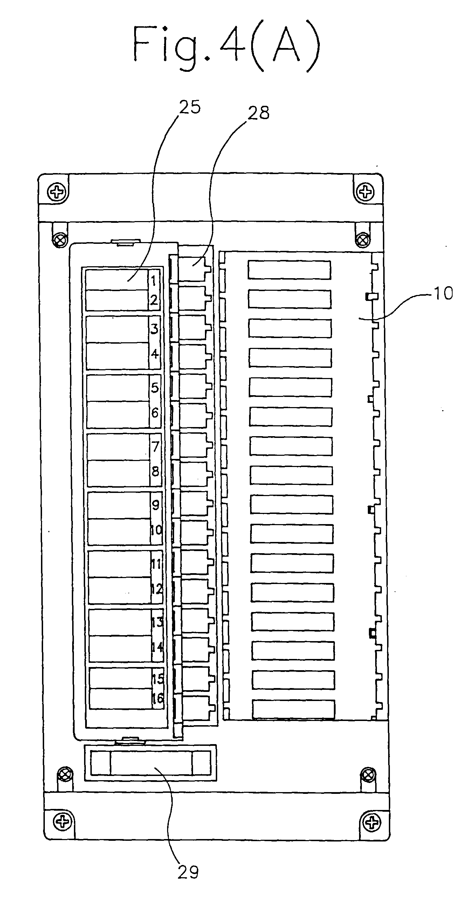

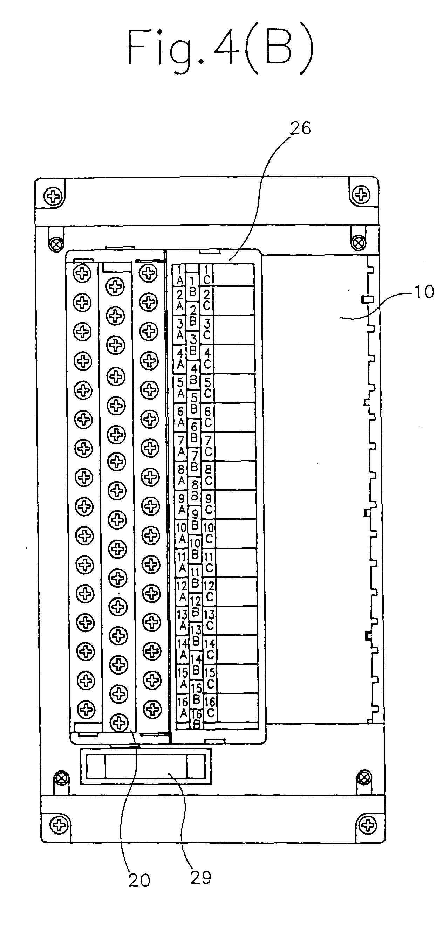

Fig. 4 is a view illustrating the sheet affixed to the terminal cover 24, in which (A) shows the terminal cover closed and (B) shows the terminal cover open. When the terminal cover 24 is closed, the slot indicator sheet 25 is seen. It is with the terminal closed like this that the input-output cards 50 are inserted into their respective slots 12, and the principle is that the tag name column 251 and the tag names on the input-output cards 50 should match. In this way, even when an input-output card 50 is pulled out of its slot 12 for maintenance work or the like, the tag of the object of the maintenance can be discerned by reference to the tag indicator column 251, and there is therefore the benefit that it is not necessary to refer to the input-output card 50 each time the tag needs confirming, and the maintenance work can be carried out smoothly.

When the terminal cover 24 is open, the terminal indicator sheet 26 is seen. In this position, the terminal indicator sheet 26 is alongside the sets of terminals of the terminal block part 20. Thus, during instrumenting work, the terminal number column 262 is close to the screw terminals, and confirmation of the terminal numbers is easy. Also, after a piece of wiring work has been completed, start-up is carried out, and, during such start-ups checking of the screw terminals and numbers can be carried out easily, and checking work can be done even when input-output cards 50 are not loaded into their slots 12.

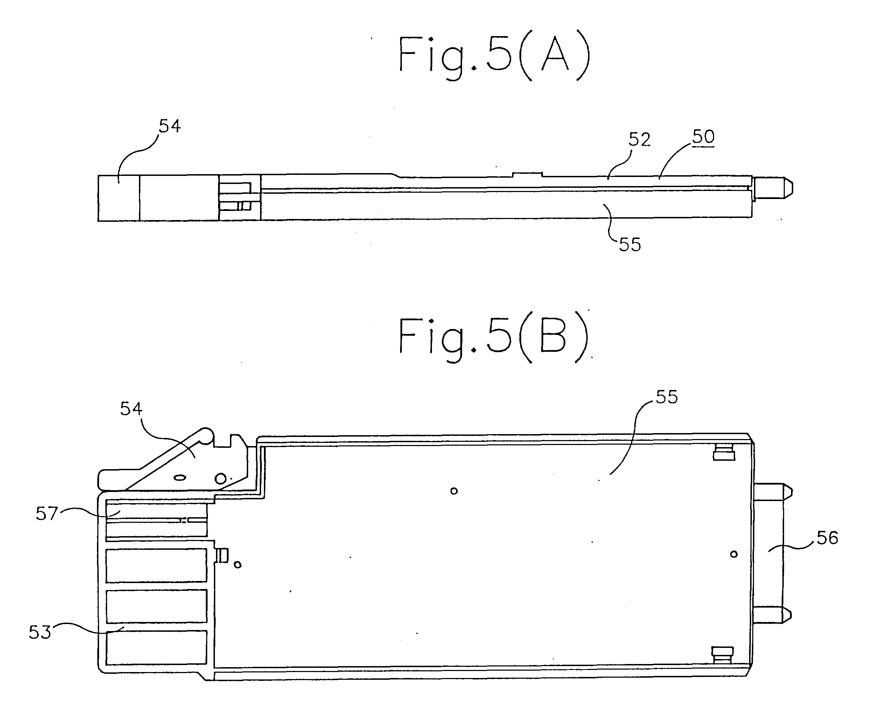

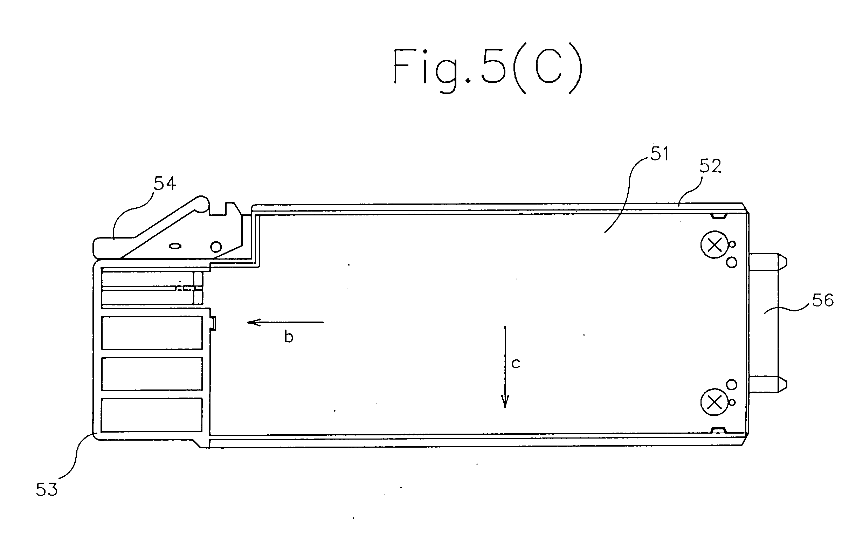

Next, the input-output card 50 that is used in the above input-output unit will be described. Fig. 5 is a detailed construction drawing of the input-output card 50, in which (A) is a plan view, (B) is a side elevational view with the cover part 55 fitted, and (C) is a side elevational view with the cover part 55 removed. In the drawing, the printed circuit board 51 has electronic components which perform the signal conversion mounted on it, and is made to be of thin form by for example surface mounted components being mounted on both sides of it. A case part 52 gives the input-output card 50 its basic shape, and the printed circuit board 51 is mounted on this case part 52 and the case part 52 protects one side of the printed circuit board 51. A fan part 53 performs cooling, and preferably is made integrally with the case part 52 from die cast aluminum or the like, so that it can conduct heat smoothly. An ejector portion 54 is mounted on the end of the front of the case part 52, and is used when the card 50 is taken out of the card accommodation chamber 10. A cover 55 protects the other side of the printed circuit board 51, and is fitted to the case part 52. A connector 56 is mounted on the back of the input-output card 50, and mates with a connector 16. A light guide part 57 is mounted on the fan part 53, and guides light emitted by a light emitting device 58, which is mounted on the printed circuit board 51 and indicates the operating state of the input-output card 50, to the front of the input-output card 50.

Next, the assembly procedure of a device constructed in this way will be explained. First, the ejector part 54 is mounted on the case part 52. Then, the light guide part 57 is inserted into a fitting groove formed in the fan part 53. The printed circuit board 51 is then positioned in its predetermined position in the case 52 and fixed in place with screws. In this, by the printed circuit board being moved in the directions shown by the arrows b and c in Fig.5, positioning is carried out smoothly. Finally, the cover part 55 is fitted to the case part 52. As necessary, a nameplate showing a tag is affixed to the front of the case part 52.

In this way, because the printed circuit board 51 is entirely covered by the case part 52 and the cover part 55, there is the benefit that there are no exposed electronic components and the reliability is good. For example, even if electrically conducting matter falls, there is no danger of shorting of the electronic components, and during handling also no outside forces act directly on the parts. And, although the input-output card 50 is accommodated in the card accommodation chamber 10, because the fan part 53 is exposed to the outside air, there is the benefit that heat generated on the printed circuit board 51 is conducted by the case part 52 and the cover part 55 to the fan part 53, is released into the outside air, and the heat dissipation efficiency is therefore good.

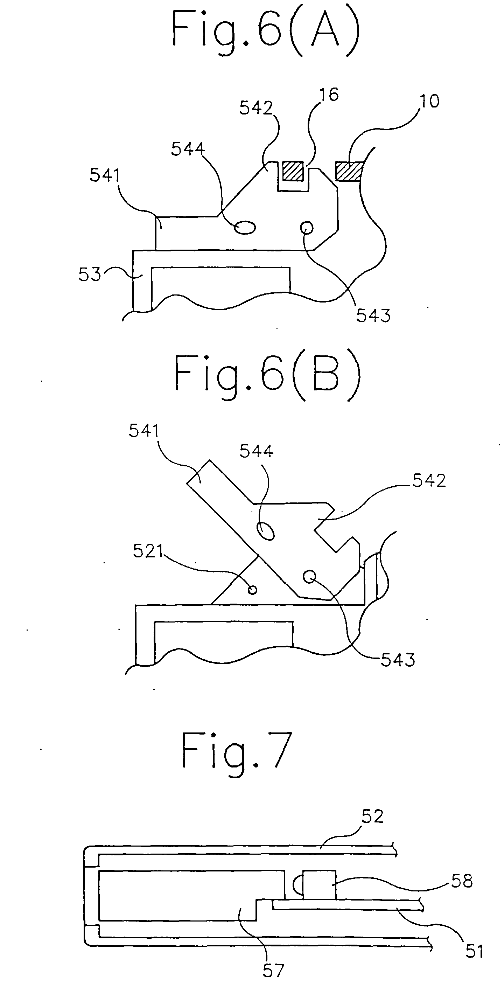

Fig. 6 is a view illustrating the ejector part 54. The ejector part 54 has a lever portion 541 which provides an ejecting force, an engaging portion 542 having a recessed portion which engages with a window portion 16 formed in the card accommodation chamber 10, a shaft portion 543 which serves as a pivot, and a lock portion 544 which fixes the ejector part 54 to the case part 52. The lock portion 544 is a concave portion which engages with a convex portion 521 mounted on the side of the case part 52. In this way, by the provision of the lock portion 544, because the ejector part 54 is restrained in an attitude in which it holds the input-output card 50 in the state in which it is mated with the connector 16, there is the benefit that the input-output card 50 is prevented from accidentally slipping out of the connector 16 as a result of vibrations or the like, and the reliability is increased.

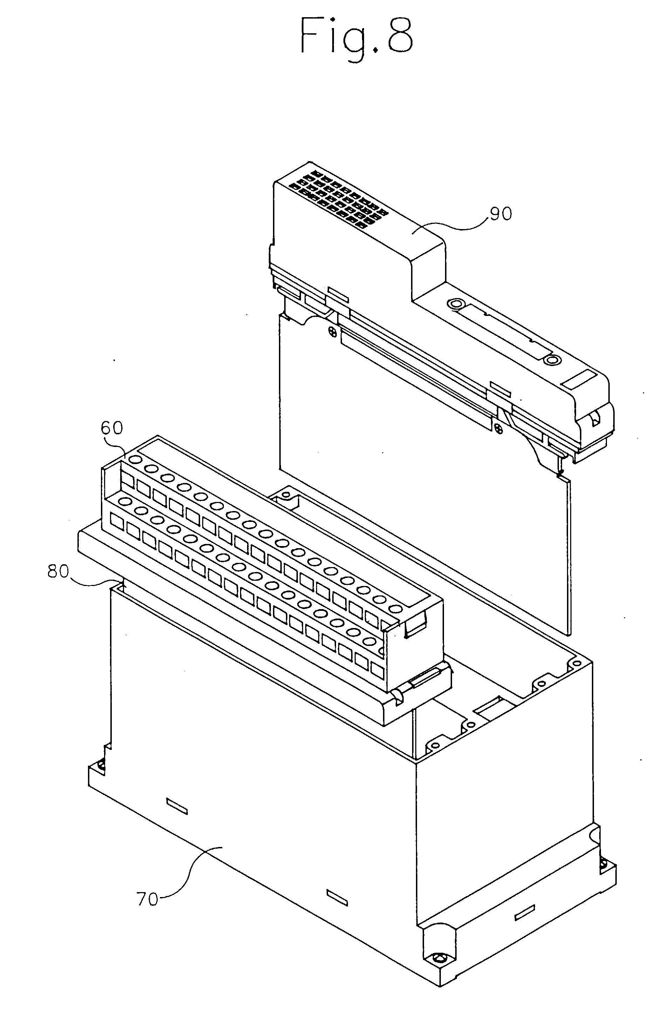

Fig. 7 is a view illustrating the device which shows the operating state of the input-output card 50. The light emitting device 58 is mounted on the printed circuit board 51, and because light from the light emitting device 58 is guided to the front of the card by the light guide part 57, assemblability is good. Conventionally, as disclosed in Japanese Laid-Open Patent Publication No. H3-1579, a light emitting device of special shape has been used, but because in this preferred embodiment the light guide 57 is used, there is the benefit that the assemblability is good and relatively few components are required.

In the input-output unit described above, because the heat generated in the input-card 50 is efficiently dissipated by the case part 30, there is the benefit that satisfactory heat dissipation can be achieved even with a small box body. And, because no terminal blocks are mounted on the input-output cards 50, and the signal wires are connected to the specially mounted terminal block part 20, and the input-output cards 50 are connected to connectors at the back board 14 side, there is the benefit that little positioning of wires is required and the wiring and assembly work can be carried out smoothly.

### Preferred Embodiment

Next, a preferred embodiment will be described. Fig. 8 is a perspective construction drawing of a preferred embodiment of the present invention. An input-output nest 70, which can be made of aluminum when good heat dissipation is required, as in the case of the case part 30 discussed above, and can be made of plastic when heat dissipation need not be considered, has inside it two chambers which each accommodate two input-output printed circuit boards 80. The input-output printed circuit boards 80 have circuits which perform conversion between the signal forms used on the control device side and the signal forms used on the field devices side; because, for reasons relating to increasing the signal transfer speed, parallel signals are used in the bus, and, in order to keep down the number of cores, serial signals (in the case of digital signals) and analog signals are used in the signal wires, the input-output printed circuit boards 80 perform conversion of these signals. An interface section 90 has the field device side signal wires connected to it and sends and receives these signals to and from an input-output printed circuit board 80; it is of connector type for use with multiple core cable, and has indicators for indicating the state of the signals in the input-output printed circuit board 80. A terminal block 60, like the interface section 90, can have the field device side signal wires connected to it and is for sending and receiving these signals to and from an input-output printed circuit board 80; it is used in cases when the signal wires are separate, individual wires.

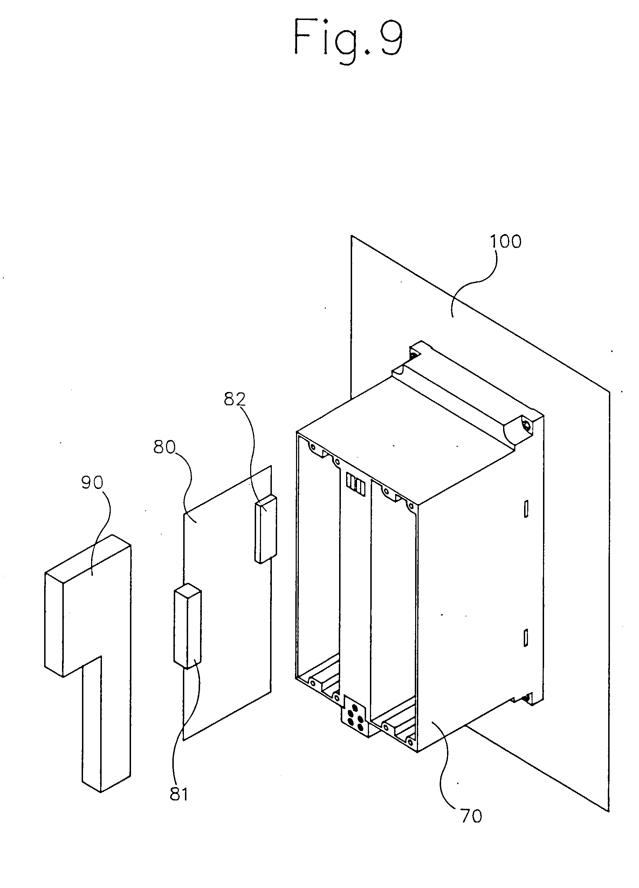

Fig. 9 is a construction view of a connector-type interface section 90 fitted to an input-output nest. In Fig. 9, parts which perform the same functions as parts in Fig. 8 have been given the same reference numerals, and their description here will be omitted. In Fig. 9, a back unit 100 is a plate member which is accommodated in a cabinet or a console, and is provided with a bus which is connected to the central control device. In the input-output nest 70, the printed circuit boards 80 which are fitted to the back unit 100 are each provided with a front connector 81 for connections to the interface section 90 or a terminal block 60 and a rear connector 82 for connections to the input-output nest 70.

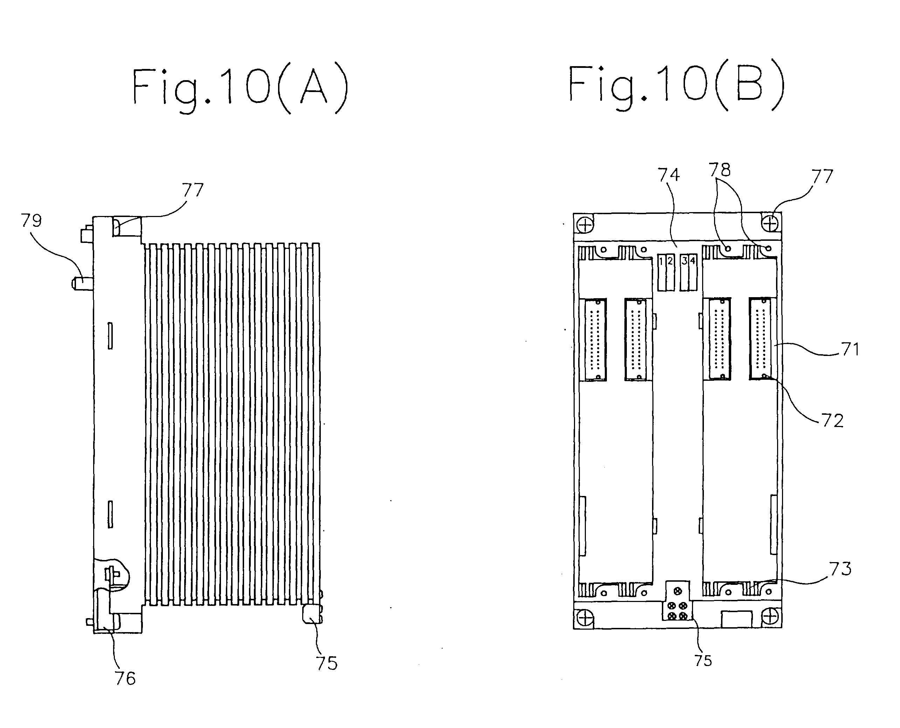

Fig. 10 is a detailed construction view of the input-output nest 70, in which (A) is a side elevational view and (B) is a front elevational view. A back board 71 is mounted at the back of the input-output nest 70, and connectors 72 used for connections to the printed circuit board 80 are mounted on the back board 71. Card guide portions 73 guide the printed circuit boards 80 in the insertion direction and ensure the connection of the connectors 72 with the rear connectors 82; the card guide portions are also called slots. A wiring work area 74 is provided in the central portion of the front of the input-output nest 70, and, because the chambers which accommodate the printed circuit boards 80 are located on each side of this, the wiring work area 74 is also a wall separating these two chambers.

An earth part 75 is a group of terminals mounted at the bottom of the wiring work area 74, and terminals for earthling the printed circuit boards 80 with respect to the box body are mounted here. An metal earthling fitting 76 provides earthling when the input-output nest is fitted to the back unit 100. Mounting screws 77 are used to mount the input-output unit 70 on the back unit 100; in this example, a mounting screw 77 is provided at each of the four corners of the input-output nest 70. Interface fitting portions 78 are provided near the card guide portions 73, and are fitting holes for fitting the interfaces 90 to the slots. Projecting portions 79 are rod-shaped projections mounted on the back face of the input-output nest 70, and engage with concave portions provided in the back unit 100 and facilitate positioning. In this example, the projecting portions 79 are provided in two places, a connector (not shown in the drawings) is disposed between them, and they guide the mating of this connector with a connector on the back unit side. As a result, even in cases such as when fitting has to be carried out in a confined space, or it is difficult to check from the side that the connectors are properly mated, proper mating can be carried out and the installation work is made easier and the reliability is improved. When the interface section 90 is a terminal block, the wiring work area 74 is used as a working space in which to carry out connection of the signal wires, and, even when terminal blocks are mounted over both of the chambers, the wiring work can be carried out smoothly.

The assembly of a device constructed in this way will be described next. The amount of heat produced by the input-output printed circuit board 80 varies, depending on the type of signals handled and the signal conversion method. The input-output nest 70 is provided with slit-form openings for heat dissipation, and is designed so that for up to a certain amount of generated heat the increase in the interior temperature remains at tolerable value. According to the amount of heat generated by the input-output printed circuit board 80 and the quantity of components mounted on it, although each chamber is capable of accommodating two boards, one circuit board may be accommodated in each chamber, or altogether one board only may be accommodated in the two chambers.

Because the interface section 90 is fixed to the interface fitting portions 78, and connection to the input-output printed circuit board 80 accommodated in this slot is performed thereby, the connecting work can be carried out smoothly. And, the width of the interface section 90 can be one slot width or two slot widths, or in some cases may be made wider, occupying the wiring work area 74. Because this kind of wide interface section 90 is allowed, there is a high degree of design freedom.

According to the invention of the preferred embodiment described above, because an industrial control equipment input-output unit is constructed from the three modules that are the general input-output nest 70, the input-output printed circuit board 80 which performs signal conversion, and the interface 90 or the terminal block 60, and these are combined according to the requirements of the system to be served, there are the benefits that the system can be built with a standardized nest form, expansion and alterations can be done easily, and cost reductions based on mass-production can be sought.

### Preferred Embodiment of the Terminal Block 60

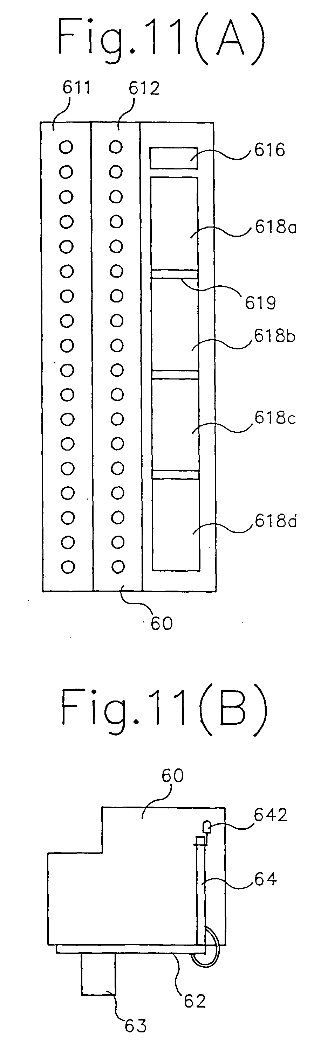

Next, the terminal block 60 used in the invention of the preferred embodiment will be described. Fig. 11 is a schematic construction view of the terminal block 60, in which (A) is an upper surface view and (B) is a side elevational view. In Fig. 11, the terminal block 60 is made of an insulating material such as plastic, and is provided with a lower terminal row 611 and an upper terminal row 612, each row having 17 terminals. A ready indicator chamber 616 and a circuit board accommodating chamber 618 divided into four chambers are disposed in a row parallel to the lower terminal row 611 and the upper terminal row 612, and the chambers of the circuit board chamber 618 are separated from each other by circuit board guides 619. A back board 62 is mounted on the bottom of the terminal block 60, and has a wiring pattern which is connected to the terminals. A connector 63 is mounted on the bottom of the back board 62, and sends the signals from the signal wires connected to the terminals out through a connector (not shown in the drawings) connected to an outside device. An indicator circuit board 64 is accommodated in the circuit board accommodation chamber 618, and in this example light emitting devices 642 are shown mounted on the indicator circuit board 64, but when other expansion functions such as temperature compensation units are to be provided, other option circuit boards are fitted.

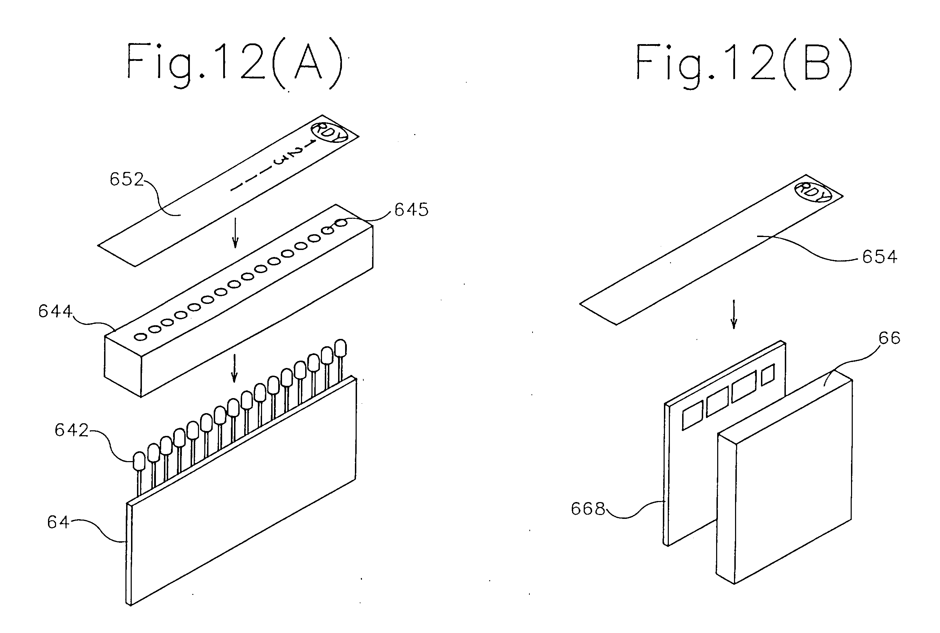

Fig. 12 is a view illustrating an expansion function to be fitted into the circuit board accommodation chamber, in which (A) shows the case of a indicator function and (B) shows the case of a temperature compensation unit. In the case of the indicator function, a indicator circuit board 64 is used. The indicator circuit board 64 has light emitting devices 642 mounted on it in four groups corresponding to the circuit board accommodating chamber 618 which is divided into four chambers, and spaces corresponding to the circuit board guides 619 are provided between the groups of light emitting devices. The circuit board guides 619 also perform the function of confining the indicator circuit board 64 to its prescribed position. An partitioned light guide part 644 is a member formed of an opaque plastic; the partitioned light guide part 644 is mounted on the upper surfaces of the circuit board guides 619, and accommodates the light emitting devices 642 in light guide holes 645. An indicator sheet 652 is affixed to the upper surface of the partitioned light guide part 644 and indicates the terminal numbers corresponding to the light emitting devices 642 which light up and go out in the light guide holes 645.

The temperature compensation unit 66 makes contact with the terminals and measures their temperature, and is necessary when an accurate temperatures are to be measured with thermocouples. In this example, because it is accommodated in the chambers of the circuit board accommodation chamber 618, one unit is provided for four terminals. For this kind of temperature compensation unit 66, for example the unit disclosed in Japanese Laid-Open Utility Model Publication No. H5-36329, by the present inventors, is suitable. A cover sheet 668 is fitted onto the surface of the terminal side of the temperature compensation unit 66; windows are formed in the side which faces the terminals, and temperature sensors are pushed against the terminals. A ready sheet 654 is affixed to the upper surface of the temperature compensation unit 66; the ready sheet 654 serves the indicator in the ready indicator chamber 616, and there is no particular indication on the circuit board accommodation chambers 618 portion.

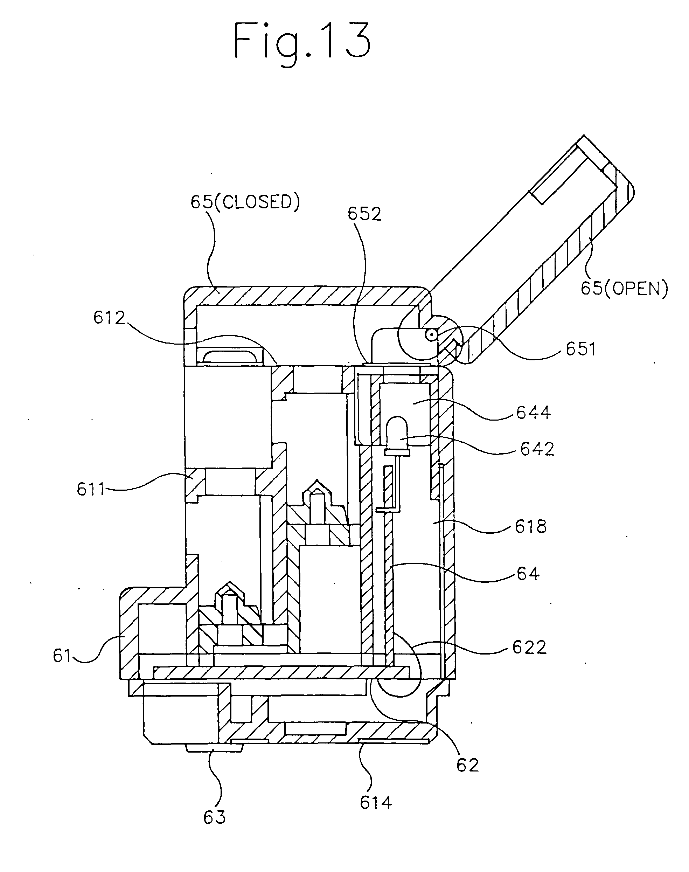

Fig. 13 is a cross-sectional view of a terminal block which has a indicator function. The terminal constructions in the chambers of the lower terminal row 611 and the upper terminal row 612 are omitted in this view, but for example the terminals having screw falling prevention mechanisms disclosed in Japanese Laid-Open Utility Model Publication No. H4-102568 are suitable. A main body 61 is the main structural member of the terminal block 60, and is made of plastic. A back plate 614 covers a back board 62, and is fitted to the bottom surface of the terminal block 60.

A connecting cable 622 connects the back board 62 to the indicator circuit board 64, and supplies signals for controlling the illumination of the light emitting devices 642 from the back board 62 side. The light emitting devices are bent in the end surface direction of the indicator circuit board 64 and are received by the partitioned light guide part 644. A cover 65 opens and closes about a hinge part 651 mounted on the terminal block 60; when the cover is opened, signal line connection work on the terminals can be performed easily, and when the cover 65 is closed, the indicator sheet 652 is positioned above the partitioned light guide part 644 and the operator can easily discern which of the terminals it is whose state is being indicated by the light emitting devices 642.

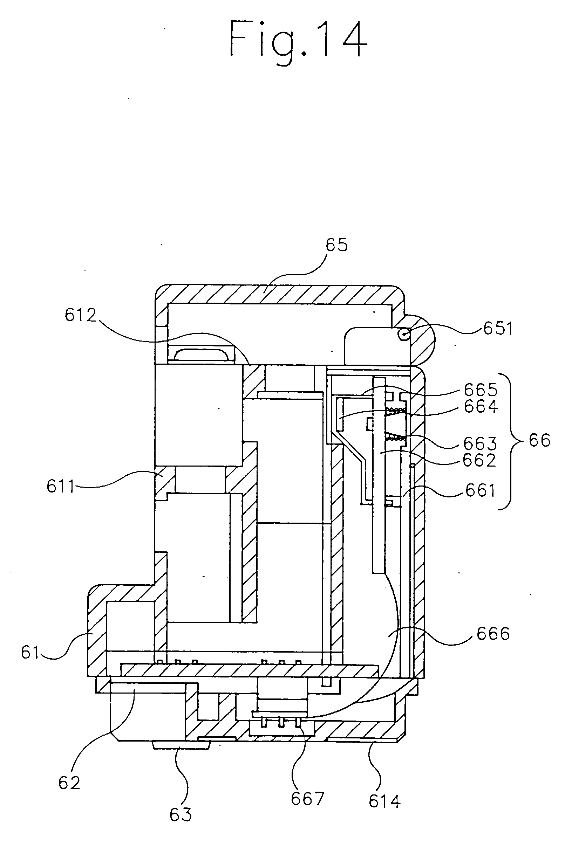

Fig. 14 is a cross-sectional view of a terminal block having a temperature compensation unit 66. Explaining now the detailed construction of the temperature compensation unit 66, it has a case portion 661 of an external shape suitable for insertion into the circuit board accommodation chamber 618, and a printed circuit board 662 is accommodated inside it. A spring 663 is mounted between the case portion 661 and the printed circuit board 662, and by pushing the printed circuit board 662 to the terminal side this spring 663 causes the temperature sensors 664 to make contact with the terminals. A metal holding fitting 665 has its entirety fixed to the printed circuit board 662, and the temperature sensors 664 are mounted integrally with it. A cable 666 carries the measurement signal produced by the temperature sensor 664 to the back board 62 through a compensation connector 667 after it has been converted into an electronic signal by the printed circuit board 662. In this example, by using flexi-cable for the cable 666, the connection work of the signal wires is carried out smoothly. It is noted that because thermocouple temperature compensation is basic instrumentation engineering knowledge, an explanation of it here is omitted.

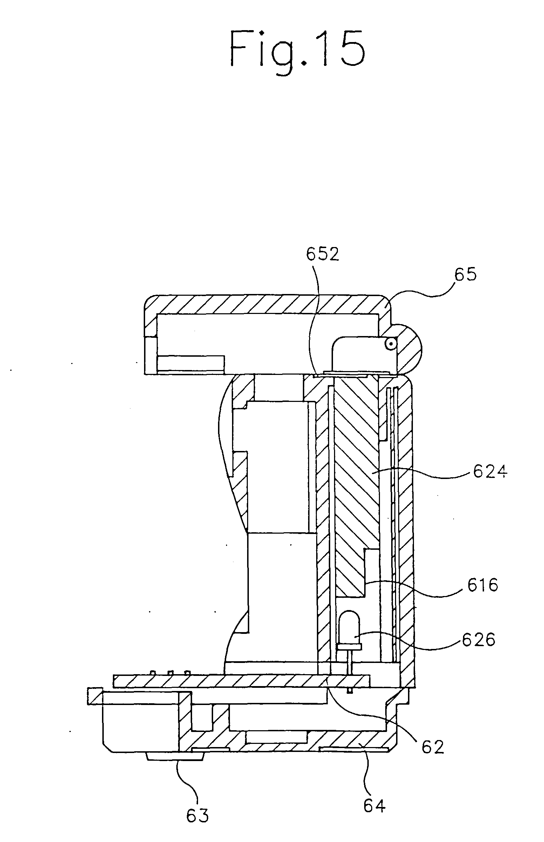

Fig. 15 is a cross-sectional view illustrating the details of the ready indicator chamber 616. A light emitting device 626 is mounted at the edge of the back board 62, and the operating state of the terminal block 60 is indicated by this light emitting device 626. A light guide 624 is accommodated in the ready indicator chamber 616, and this light guide 624 guides the light emitted by the light emitting device 626 to the RDY of the indicator sheet 652. This function is an essential function of the terminal block, and is provided commonly for all types of terminal block.

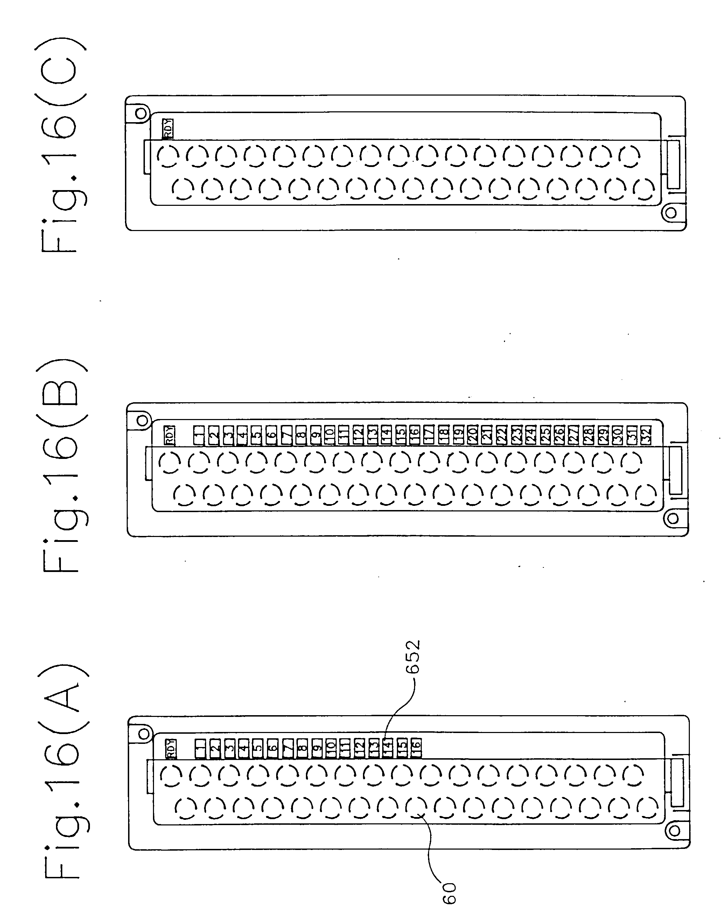

Fig. 16 is a plan view of the terminal block main body with the indicator sheet affixed to it, in which (A) shows a sixteen contact point indicator, (B) shows a thirty-two point indicator and (C) shows a indicator for the ready signal only. When the indicator function is sixteen points, corresponding terminals of the lower terminal row 611 and the upper terminal row 612 are used as sets of one plus terminal and one minus terminal. Accordingly, the contact point signal indication is also performed using the signals of the terminal sets. The ready signal RDY and the contact point terminal numbers 1 ∼ 16 are indicated on the indicator sheet 652, and this makes easy the visual confirmation of which of the terminals corresponds to which of the light emitting devices 642 accommodated in the circuit board accommodation chamber 618.

When the indicator function is thirty-two points, independent signal wires are connected to the terminals of the lower terminal row 611 and the upper terminal row 612. Surplus terminals in the lower terminal row 611 and the upper terminal row 612 are used as the respective minus terminals. The ready signal RDY and the terminal numbers 1 ∼ 32 of the contact points are indicated on the marker sheet 652.

Ready sheet 654 is fixed on the terminal block 60 and it shows only the ready signal RDY in cases such as when the temperature compensation unit 66 is accommodated in the circuit board accommodation chamber 618, and when the indicator circuit board 64 is not fitted. Because the ready signal RDY is necessary for all the types of terminal, by this the operating state of the terminal block can be confirmed.

According to the invention disclosed in the preferred embodiment of the terminal block 60 described above, because the operating state of the terminal block is indicated by the ready indicator 616, the operating state of the terminal block can be checked whatever the type of the terminals, and there is the benefit that the common use of the terminal block 60 can be promoted and few molds are required. Also, because the indicator circuit board 64 and the temperature compensation unit 66 and the like are provided or not provided case-by-case, according to the requirements of each type of terminal block, there is the benefit that optional functions matched to the signal line type can be realized with a small number of components.

### Preferred Embodiment of the Interface Section 90

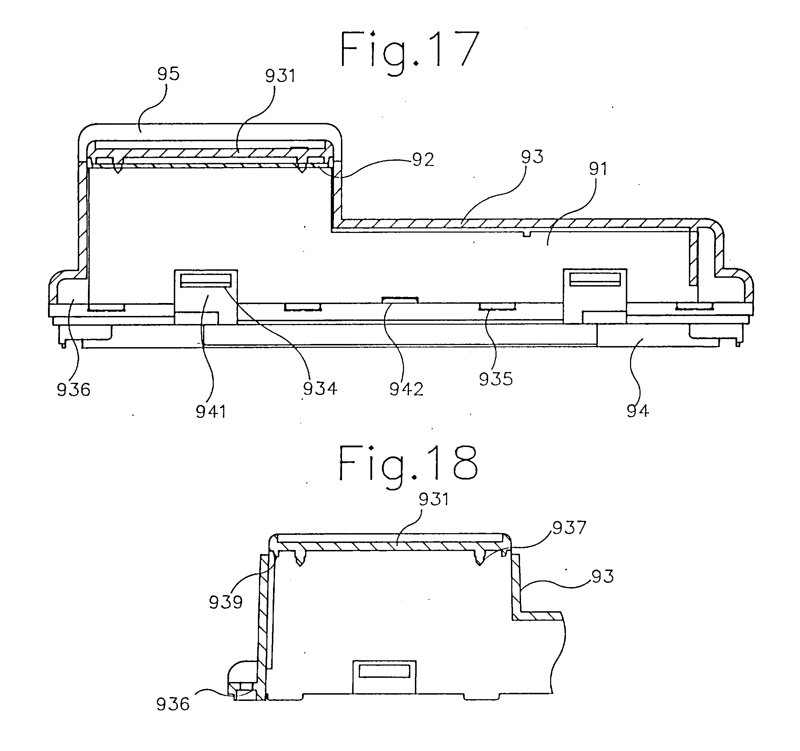

Next, the connector-type interface section 90 used in the invention of the preferred embodiment will be described. Fig. 17 is a construction drawing showing a preferred embodiment of the connector-type interface section 90, with the case being shown with hatching lines. In Fig. 17, a printed circuit board 91 has electronic devices and connecters, etc., mounted on it, and is roughly L-shaped. A indicator circuit board 92 is provided with light emitting devices such as LEDs disposed in a matrix form, and makes a T-shape in its positional relationship with the printed circuit board 91. The printed circuit board 91 is accommodated in the case 93 side surface direction, and the indicator circuit board 92 is accommodated behind an indicator window 931 mounted at the front of the case 93. A cover 94 is fitted to the back of the case 93, and holds both the printed circuit board 91 and the indicator circuit board 92 in the case 93. A box body for electronic apparatus, such as the input-output nest shown in Fig. 8, is fitted to this case 93, and an input-output printed circuit board 80 for signal processing is also connected to the case 93 via a connector 911. Also, it is desirable that an indicator window cover 95 made of transparent plastic or the like be fitted over the indicator window 931.

Fig. 18 is an enlarged view of the vicinity of the indicator window 931. Holding projections 937, which position the indicator circuit board 92, and indicator circuit board abutting portions 939, which abut with the indicator window 931 side edge of the indicator circuit board 92, are provided on the back of the indicator window 931.

The indicator circuit board abutting portions 939 are line-form projections mounted in the widthways direction of the indicator window 931.

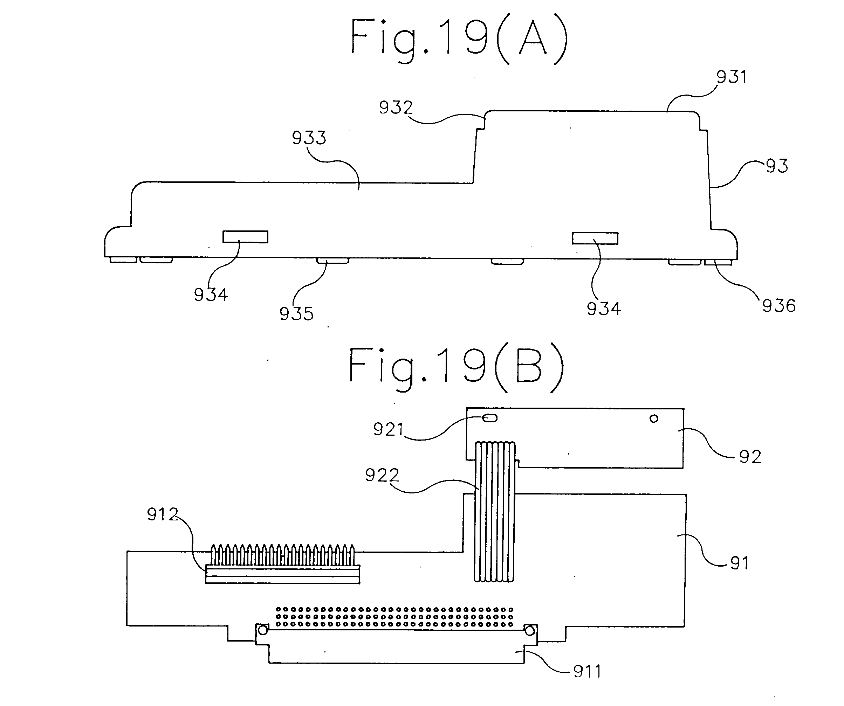

Fig. 19 is a development parts view, with the cover 94 removed. Windows corresponding to the light emitting devices are formed in a four row by eight column matrix layout in the indicator window 931. When necessary, it is beneficial to attach name plates indicating the object of the indicator and LEDs indicating the current flow/non-flow state. A indicator circuit board accommodation chamber 932 is located behind the indicator window 931 and accommodates the indicator circuit board 92. A printed circuit board accommodating chamber 933 occupies most of the case 93 and accommodates the printed circuit board 91. Engaging holes 934 are engaged with by case mounting claws 941 mounted on the cover 94, and in this example consist of rectangular windows formed in two places on each side of the case 93. Cover guide projecting portions 935 are for facilitating the mating of the case 93 and the cover 94, and thin portions which are thinner than the rest of the cover 94 are formed in corresponding positions on the cover 94 side. Case guide projections can be provided on the cover 94 side also, and thin portions can be formed on the case 93 side. Nest mounting portions 936 are screw holes formed in the upper and lower ends of the surface of the case 93 which abuts with the cover 94, and are used in fitting the case 93 to a nest or a wall body or the like.

A connector 911 is mounted on the back of the printed circuit board 91, and this is connected to an input-output printed circuit board 80 for signal processing. A connector 912 is mounted on the front of the printed circuit board 91, and this is used in connecting signal wires connected to outside devices. Signals inputted through the connector 912 pass through the connector 912 and the input-output printed circuit board 80 and are used in connection with the bus that is on the nest side. The cable 922 is a multiple core flat cable which connects the printed circuit board 91 and the indicator circuit board 92 and carries the illumination drive signals of the indicator circuit board 92. Holding holes 921 are openings which are provided in two locations on the indicator circuit board 92 and engage with the holding projections 937. To allow for dimensional errors these holes are oblong in shape.

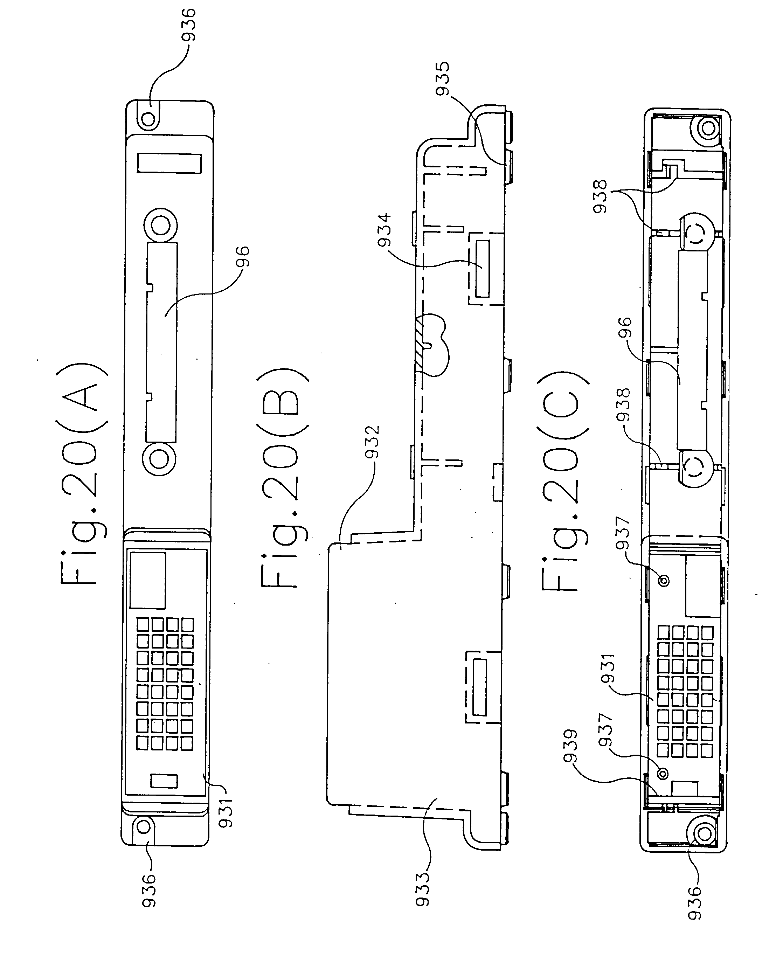

Fig. 20 is a component view of the case 93, in which (A) is a front elevational view, (B) is a side elevational view, and (C) is a back elevational view. A connector fitting hole 96 has a cable which connects with the connector 912 fitted to the printed circuit board 91 fitted to it, and, in order to perform the connection completely, screw holes are formed at both ends. Circuit board holding grooves 938 are portions cut out of ribs formed in the widthways direction of the case 93, and position the printed circuit board 91. The holding projections 937 are disposed in positions where they do not overlap with the circuit board holding grooves 938. The cover 94 is also provided with a connector mounting hole 96 for fitting the cable connecting with the connector 911 mounted on the printed circuit board 91.

The assembly of a device constructed in this way will now be explained. First, the indicator circuit board 92 is fitted onto the back of the indicator window 931 in such a way that the holding projections 937 on the indicator window 931 engage with the holding holes 921. Then, the printed circuit board 91 is inserted along the circuit board holding grooves 938 and thereby accommodated in the circuit board accommodation chamber 933. During this process, differences in attitude between the indicator circuit board 92 and the printed circuit board 91 are absorbed by the cable 922. Finally, when the cover 94 is fitted to the case 93, the indicator circuit board 92 and the printed circuit board 91 are fixed in the case together, en bloc.

According to the invention disclosed in the preferred embodiment of the connector-type interface section 90 described above, because when finally the cover 94 is fitted to the case 93 the indicator circuit board 92 and the printed circuit board 91 are fixed in the case 93 en bloc, there is the benefit that the assembly work can be carried out more smoothly than in conventional cases wherein the display circuit board 92 and the printed circuit board 91 are fixed to the case 93 one by one. And, because the space that conventionally has been necessary for this successive fixing is reduced, there is also the benefit that a contribution is made to increasing the density of the electronic apparatus.

## Claims

1. An input-output unit for performing signal receiving and delivery mediation between an industrial control equipment and field devices controlled by it, the input-output unit comprising
an input-output nest (70), suitable to be connected by a bus to the industrial control equipment,
an input-output printed circuit board (80), which is accommodated in the input-output nest (70) and performs conversion between the signal forms handled by the industrial control equipment and the signal forms handled by the field devices;
a front connector (81) provided at the edge of the input-output printed circuit board(80) so as to be set at the front of the input-output nest (70);
a terminal block (60) comprising arranged terminals, which are lined up in a plurality of rows and suitable to be connected to the field device side signal wires, in cases when the signal wires are separate, individual wires, and suitable to be connected to the front connector (81);
an interface section (90) suitable to be connected to the field device side signal wires in cases when the signal wires have a connector for use with multiple core cable, and suitable to be connected to the front connector (81);
wherein either the terminal block (60) or the interface section (90) is selectively fitted to the front connector (81) and the input-output nest (70).

2. An input-output unit according to claim 1, wherein the terminal block (60) has a ready indicator chamber (616) and a circuit board accommodation chamber (618), both chambers being disposed in the row direction in which the terminals are disposed, and has a back board (62) mounted on the bottom surface of the terminal block (60), which has a pattern which is connected to the terminals, and wherein in the ready indicator chamber (616) light emitted by a light emitting device (626), mounted on the back board (62), for indicating the operating state of the terminal block (60), is guided to the upper surface of the terminal block (60).

3. An input-output unit according to claim 2, wherein an indicator circuit board (64) on which light emitting devices (642), which light up and go out according to the signal states of the terminals, is accommodated in the circuit board accommodation chamber (618), and wherein an partitioned light guide part (644) which is on the upper surface of the terminal block (60) and which in the direction in which the terminals are lined up separately displays the light emitted by each of these light emitting devices, is mounted in the circuit board accommodation chamber (618).

4. An input-output unit according to claim 2, wherein a temperature compensation unit (66), which makes thermal contact with a terminal to which a thermocouple is connected and measures the temperature of that terminal, is mounted in the circuit board accommodation chamber (618).

5. An input-output unit according to claim 1, wherein the interface section (90) comprises a printed circuit board (91) and an indicator circuit board (92) which has light emitting devices mounted on it and is connected to this printed circuit board (91) through a cable (922), a case (93) whose side surface is larger than the printed circuit board (91) and which accommodates the indicator circuit board (92) behind an indicator window (931) provided in the front of the case (93), and a cover (94) which is fitted to the back of the case (93), and wherein the indicator circuit board (92)is provided with holding holes (921) and the indicator window (931) is provided with holding projections (937) which project from the back surface of the display window and engage with the holding holes (921) and the indicator circuit board (92) is held by the holding projections (937) and an edge portion of the printed circuit board (91).

## Patentansprüche

1. Eine Eingabe/Ausgabe-Einheit zum Durchführen einer Signalempfangs- und Abgabevermittlung zwischen einer industriellen Steuerausrüstung und durch diese gesteuerte Feldvorrichtungen, wobei die Eingabe/Ausgabe-Einheit umfaßt:
eine Eingabe/Ausgabe-Aufnahmeeinrichtung (nest) (70), die zum Verbinden durch einen Bus mit der industriellen Steuerausrüstung geeignet ist;
eine gedruckte Eingabe/Ausgabe-Leiterplatte (80), die in der Eingabe/Ausgabe-Aufnahmeeinrichtung (70) untergebracht ist und die eine Umwandlung zwischen den durch die industrielle Steuerausrüstung gehandhabten Signalformen und den durch die Feldvorrichtungen gehandhabten Signalformen durchführt;
einen vorderen Verbinder (81), der an dem Rand der gedruckten Eingabe/Ausgabe-Leiterplatte (80) vorgesehen ist, um an der Vorderseite der Eingabe/Ausgabe-Aufnahmeeinrichtung (70) angeordnet zu werden;
einen Anschlußblock (60) mit angeordneten Anschlüssen, die in einer Mehrzahl von Reihen aufgereiht sind und die geeignet sind, um mit den Signaldrähten auf der Feldvorrichtungsseite in Fällen verbunden zu werden, wenn die Signaldrähte getrennte einzelne Drähte sind, und die zum Verbinden mit dem vorderen Verbinder (81) geeignet sind;
einen Schnittstellenabschnitt (90), der zum Verbinden mit den Signaldrähten auf der Feldvorrichtungsseite in Fällen, wenn die Signaldrähten einen Verbinder zur Verwendung mit einem mehradrigen Kabel aufweisen, geeignet ist, und der zum Verbinden mit dem vorderen Verbinder (81) geeignet ist;
wobei entweder der Anschlußblock (60) oder der Schnittstellenabschnitt (90) selektiv an den vorderen Verbinder (81) und die Eingabe/Ausgabe-Aufnahmeeinrichtung (70) angebunden ist.

2. Eine Eingabe/Ausgabe-Einheit gemäß Anspruch 1, wobei der Anschlußblock (60) eine Bereit-Anzeigekammer (616) und eine Leiterplatten-Unterbringungskammer (618) aufweist, wobei beide Kammern in der Reihenrichtung, in der die Anschlüsse angeordnet sind, angeordnet sind, und eine an der unteren Oberfläche des Anschlußblocks (60) angebrachte Rückplatte (62) aufweist, die ein Muster aufweist, das mit den Anschlüssen verbunden ist, und wobei in der Bereit-Anzeigekammer (616) durch eine an der Rückplatte (62) angebrachte, lichtemittierende Vorrichtung (626) emittiertes Licht zum Angeben des Betriebszustands des Anschlußblocks (60) zu der oberen Oberfläche des Anschlußblocks (60) geleitet wird.

3. Eine Eingabe/Ausgabe-Einheit gemäß Anspruch 2, wobei eine Anzeige-Leiterplatte (64), an der lichtemittierende Vorrichtungen (642) gemäß den Signalzuständen der Anschlüsse aufleuchten und ausgehen, in der Leiterplatten-Unterbringungskammer (618) untergebracht ist, und wobei ein unterteilter Lichtleiterteil (644), der sich an der oberen Oberfläche des Anschlußblocks (60) befindet und der das von jeder dieser lichtemittierenden Vorrichtungen emittierte Licht in der Richtung, in der die Anschlüsse aufgereiht sind, getrennt anzeigt, in der Leiterplatten-Unterbringungskammer (618) untergebracht ist.

4. Eine Eingabe/Ausgabe-Einheit gemäß Anspruch 2, wobei eine Temperaturkompensationseinheit (66), die thermischen Kontakt mit einem Anschluß herstellt, an dem ein Thermoelement verbunden ist, und die Temperatur dieses Anschlusses mißt, in der Leiterplatten-Unterbringungskammer (618) angebracht ist.

5. Eine Eingabe/Ausgabe-Einheit gemäß Anspruch 1, wobei der Schnittstellenabschnitt (90) umfaßt: eine gedruckte Leiterplatte (91) und eine Anzeige-Leiterplatte (92), die lichtemittierende Vorrichtungen an ihr angebracht hat und die mit dieser gedruckten Leiterplatte (91) durch ein Kabel (922) verbunden ist, ein Gehäuse (93), dessen Seitenoberfläche größer als die gedruckte Leiterplatte (91) ist und das die Anzeige-Leiterplatte (92) hinter einem in der Vorderseite des Gehäuses (93) vorgesehenen Anzeigefenster (931) unterbringt, und eine Abdeckung (94), die an der Rückseite des Gehäuses (93) eingepaßt ist, und wobei die Anzeige-Leiterplatte (92) mit Haltelöchern (921) versehen ist und das Anzeigefenster (931) mit Haltevorsprüngen (937), die von der Rückfläche des Anzeigefensters vorstehen und mit den Haltelöchern (921) in Eingriff stehen, versehen ist, und die Anzeige-Leiterplatte (92) durch die Haltevorsprünge (937) und einem Randabschnitt der Leiterplatte (91) gehalten wird.

## Revendications

1. Une unité d'entrée/sortie pour effectuer une médiation de réception et d'amenée de signal entre un appareil de commande industriel et des dispositifs extérieurs commandés par celui-ci, l'unité d'entrée/sortie comprenant:
un élément à emboîtement d'entrée/sortie (70), convenant pour être relié, par un bus, à l'appareil de commande industriel,
une carte à circuit imprimé d'entrée/sortie (80), logée dans l'élément à emboîtement d'entrée-sortie (70) est effectuant la conversion entre les formes de signal traitées par l'appareil de commande industriel et les formes de signal traitées par les dispositifs sur site;
un connecteur avant (81) prévu sur le bord de la carte à circuit imprimé d'entrée/sortie (80) pour être fixer à l'avant de l'élément à emboîtement d'entrée/sortie (70);
un bloc à borne (60) comprenant des bornes agencées, alignées en une pluralité de rangées et convenant pour être connecté aux fils de signalisation situés côté dispositif sur site, dans les cas dans lesquels les fils de signalisation sont séparés, des fils individuels, et convenant pour être connecter au connecteur avant (81) ;
une section d'interface (90) convenant pour être connectée aux fils de signalisation situés côté dispositif sur site, dans les cas dans lesquels les fils de signalisation ont un connecteur devant être utilisé avec un câble à plusieurs conducteurs, et convenant pour être connectée au connecteur avant (81);
dans lequel le bloc à borne (60) ou la section d'interface (90) est montée sélectivement sur le connecteur avant (81) et l'élément à emboîtement d'entrée/sortie (70).

2. Une unité d'entrée/sortie selon la revendication 1, dans laquelle le bloc à borne (60) a une chambre d'indicateur prêt (616) et une chambre de logement de carte de circuit (618), les deux chambres étant disposées dans la direction des rangées dans laquelle les bornes sont disposées, et a un panneau arrière (62) monté sur la surface inférieure du bloc à borne (60), ayant un motif connecté aux bornes, et dans lequel de la lumière est émise dans la chambre d'indicateur prêt (616), par un dispositif photoémetteur (626), monté sur le panneau arrière (62), pour indiquer l'état de fonctionnement du bloc à borne (60), est guidée sur la surface supérieure du bloc à borne (60).

3. Une unité d'entrée/sortie selon la revendication 2, dans laquelle une carte à circuit indicateur (64), sur laquelle sont prévus des dispositifs photoémetteurs (642), qui s'éclairent et s'éteignent selon les états de signalisation des bornes, est logée dans la chambre de logement de carte de circuit (618), et dans laquelle une partie de guidage de lumière (644) subdivisée, se trouvant sur la surface supérieure du bloc à borne (60) et qui affiche séparément la lumière émise par chacun de ces dispositifs photoémetteurs, dans la direction dans laquelle les bornes sont alignées, est montée dans la chambre de logement de carte de circuit (618).

4. Une unité d'entrée/sortie selon la revendication 2, dans laquelle une unité de compensation de température (66), établissant un contact thermique avec une borne à laquelle un thermocouple est relié et mesurant la température de cette borne, est montée dans la chambre de logement de carte de circuit (618).

5. Une unité d'entrée/sortie selon la revendication 1, dans laquelle la section d'interface (90) comprend une carte de circuit imprimé (91) et une carte de circuit indicateur (92), présentant des dispositifs photoémetteurs montés sur elle et connectée à cette carte de circuit imprimé (91) par un câble (922), un boîtier (93), dont la surface latérale est plus grande que la carte à circuit imprimé (91) et qui loge la carte à circuit indicateur (92) derrière une fenêtre indicatrice (931) ménagée à l'avant du boîtier (93), et un couvercle (94) monté à l'arrière du boîtier (93), et dans laquelle la carte de circuit indicateur (92) est dotée de trous de fixation (921) et la fenêtre indicatrice (931) est dotée de saillies de maintien (937), se projetant depuis la surface arrière de la fenêtre d'affichage et venant en prise avec les trous de maintien (921), et la carte de circuit indicateur (92) étant maintenue par les saillies de maintien (937) et une partie de bordure de la carte de circuit imprimé (91).
